Europäisches Patentamt

European Patent Office

Office européen des brevets

(11) Publication number: 0 250 146
A1

## EUROPEAN PATENT APPLICATION

(21) Application number: 87305080.1

(22) Date of filing: 09.06.87

(51) Int. Cl.⁴: **H01L 23/48**

(30) Priority: 16.06.86 US 874916

(43) Date of publication of application:
23.12.87 Bulletin 87/52

(84) Designated Contracting States:
DE FR GB IT NL

(71) Applicant: **TEXAS INSTRUMENTS
INCORPORATED
13500 North Central Expressway
Dallas Texas 75265(US)**

(72) Inventor: **McLellan, Neil
17019 Planters Row
Dallas Texas 75248(US)**

(74) Representative: **Abbott, David John et al
Abel & Imray Northumberland House 303-306
High Holborn
London, WC1V 7LH(GB)**

(54) Palladium plated lead frame for integrated circuit.

(57) A palladium plated lead frame (2) for integrated
circuit devices in which a plurality of lead frames are
flood plated with a substantially uniformly thick layer
of palladium (6) over all the surfaces of each lead
frame.

Fig. 2

EP 0 250 146 A1

## PALLADIUM PLATED LEAD FRAME FOR INTEGRATED CIRCUIT

### BACKGROUND OF THE INVENTION

#### 1. Field of the Invention

This invention relates to improved lead frames for integrated circuit devices and to methods for manufacturing improved lead frames.

#### 2. Description of the Related Art

In the construction of integrated circuit devices, typically, lead frames are silver plated at the lead ends to facilitate gold wire bonding to the lead ends. The gold wires are for connecting electrically the individual leads of the lead frame to the integrated circuit. It is well known that silver has a strong affinity for sulphur and that in the presence of sulphur impurities in the air, silver sulfides are formed. The presence of such sulfides on the silver surfaces of the lead ends results in a weakened mechanical bond between the leads and gold wire. Currently, bonding temperatures are sufficiently high to drive away most sulfide impurities, however, since lower bonding temperatures offer less risk of damaging the semiconductor integrated circuit, present trends in the art are toward using lower and lower temperatures in the bonding process through the use of techniques such as thermosonic bonding. Thus, temperatures used may go low enough for the sulfide problem to worsen.

Similarly, the lead frame member for supporting the semiconductor material is also silver plated to make it easier to bond adhesively the semiconductor to the support and enhance the electrical connection with the support. The support is located at the center of the lead frame and is surrounded by the lead ends, so the support and lead ends are silver plated by masking the outer portions of the lead frame so that only the center portion is plated. This process is commonly referred to as silver spot plating. Masking is an extra step in the manufacturing process which adds to the cost of the final product.

Further adding to the cost are the considerable expenses involved in safely handling and disposing of the large quantities of cyanide present in the silver spot plating bath.

After the lead frame has been silver spot plated and packaged in a medium such as plastic, the resulting integrated circuit device is dipped in molten solder to coat the external leads. This is done to increase the solderability of the leads for subsequent board assembly and to prevent the leads from oxidizing or tarnishing.

Solder dipping subjects integrated circuit devices to a number of undesirable hazards. The solder dipping process requires that the external leads of a device first be prepared with corrosive halide fluxes, before the device is dipped. The presence on the external leads of these corrosive fluxes frequently reduces the reliability and shelf life of devices, especially those assembled with plastic packaging material. This occurs when flux residues, aided by moist environmental conditions, enter the plastic packages along the leads and come into contact with the semiconductor material inside, causing corrosion on the integrated circuit. Plastic is a desirable packaging material because of its relative inexpensiveness compared to a material such as ceramic, however, it is also more susceptible to the type of flux contamination just mentioned. This occurs due to the poor bond or seal formed between the plastic material and the leads. As a result, given the right environmental conditions, i.e., moisture coupled with long periods of disuse, the corrosive fluxes can move along the leads into the plastic package. On the other hand, when an integrated circuit is in a powered on state the heat thus generated tends to drive moisture from within the plastic package, inhibiting flux movement into the package.

A further undesirable consequence of solder dipping is the thermal shock delivered to the integrated circuit device when it comes into contact with the hot solder. It is well known that semiconductor materials are sensitive to heat and can be damaged thereby. Damage to the various components of the integrated circuit device by the heat shock is one of the factors reducing the percentage of good parts yielded by a production run.

Many present day procedures call for testing the electrical characteristics of integrated circuit devices prior to solder dipping. As a result, many good devices are rejected at test time due to poor electrical contact of the testing apparatus with uncoated external leads which have become oxidized. Some otherwise desirable lead frame materials, such as copper, are especially prone to rapid oxidation causing devices fabricated with them to be difficult to test accurately.

## SUMMARY OF THE INVENTION

In light of the above, the present invention presents a palladium plated lead frame which does not require silver spot plating or solder dipping. The palladium plating process requires that the lead frame surfaces first be plated with another metal, such as nickel, to enable the palladium to adhere better. This is called activation of the lead frame surface. If nickel is used as the activating metal, a thinner palladium layer is required than if another metal is used. The lead frame is flood plated so that all of its surfaces are covered by a palladium layer prior to wire bonding or attachment of the semiconductor integrated circuit.

The present invention provides on each lead end a palladium surface which is excellent for thermosonically bonding gold wire to the lead. In performing wire bond pull tests with the invention, it has been shown quantitatively that gold wire thermosonically bonded to a palladium plated lead end provides a mechanically stronger bond than is achieved by the prior art bond of gold wire to a silver plated lead end. Consequently, silver plating on the lead ends is not required or desirable. Two factors which contribute toward the improved bond provided by the invention are that, first, palladium is completely soluble in both gold and nickel and forms no intermetallics with either metal. Second, palladium is a noble metal in the platinum group and will not tarnish or oxidize in air at temperatures below 1,000 degrees centigrade, thus retaining indefinitely a good clean surface ready for bonding.

Also provided by the invention is palladium plating of the semiconductor support member. For the reasons given above, the palladium plated support member presents an oxide and tarnish free surface for applying an adhesive to fasten the integrated circuit to the lead frame, thus, silver plating is not required.

From the foregoing discussion, it will be appreciated that the palladium plated lead frame of the invention can be stored indefinitely after the step of palladium plating. No oxides or tarnish will form under normal storage conditions. This is an improvement over the prior art devices where the bonding steps and application of adhesives must occur soon after silver spot plating, before silver oxides and sulfides can form.

An inherent advantage of the invention, since it does not require silver plating, is the elimination of the hazards and costs associated with handling and disposing of the cyanide present in the silver plating baths.

The invention provides for palladium plating of the entire lead frame, including the portion of the leads external to the packaging medium. The palladium plating on the external leads is extremely resistant to oxidation and tarnishing as explained above. Therefore, solder dipping is not required to protect the external leads or to enable effective electrical contact of the leads with other components. Consequently, the problem of rejecting good parts during electrical characteristics testing because of poor electrical connection to the external leads is reduced considerably.

Furthermore, solder dipping is not required to increase solderability of the palladium plated external leads. Using a meniscograph tester it has been shown that the palladium plated lead frame, provided by the invention, possesses and maintains excellent solderability even after thermal cycling and six hours of steam aging. A meniscograph measures the speed and force of adherence of solder to an object. Thermal cycling is a test in which an object is exposed to temperature extremes while steam aging is a test in which an object is exposed to steam for a specified period of time.

Another factor favoring the use of palladium plating on the external leads is that palladium has a very low dissolution rate in tin/lead solder. As a result, there is little likelihood that the palladium surface will be degraded by the process of soldering the external leads to other components.

The invention eliminates the problems of flux related corrosion and thermal shock since, as mentioned above, the external leads of the invention do not require solder dipping. The elimination of solder dipping goes a long way toward making plastic packaged integrated circuits more reliable since there is no flux on the leads to enter the package.

Furthermore, because of its noble properties, palladium lead frames should adhere to plastic packaging material to a greater degree than do prior art lead frames. Such a result will ensure an improved seal between the plastic package around the leads and the leads, thereby improving the ability of the integrated circuit device to keep moisture from entering the package along the leads. The improvements provided by the invention will have the effect of making plastic packaged integrated circuits much more durable than at present, so that for the lower cost of plastic, longevity approaching that of more expensive ceramic devices may be possible.

A further advantage of the invention arises from palladium's high ductility which enables the palladium surface of the lead frame to resist cracking as the lead frame is bent to its final shape during the fabrication process. The invention provides for a lead frame in which one embodiment has palladium deposited with substantially uniform thickness on the lead frame surfaces to provide good package stress characteristics. That is, there is no unevenness caused by the plating significant enough to stress unevenly the packaging medium. This is an advantage over the prior art technique of silver spot plating which deposits metal in a localized area.

Another embodiment of the invention is a lead frame plated with 80% palladium, 20% nickel alloy rather than with pure palladium. One advantage is that less hydrogen is bound up with the alloy than with the pure palladium, thereby enabling the plating to adhere better to the lead frame.

These and other advantages and objects of the invention can be more readily understood from a reading of the specification in conjunction with the drawings.

## BRIEF DESCRIPTION OF THE DRAWING

Figure 1 is a plan view of a lead frame with attached integrated circuit. As shown, the lead frame is a section of a strip of a plurality of lead frames and shows only three leads.

Figure 2 is an end, sectional view of an integrated circuit device in accordance with the invention.

## DESCRIPTION OF THE PREFERRED EMBODIMENTS

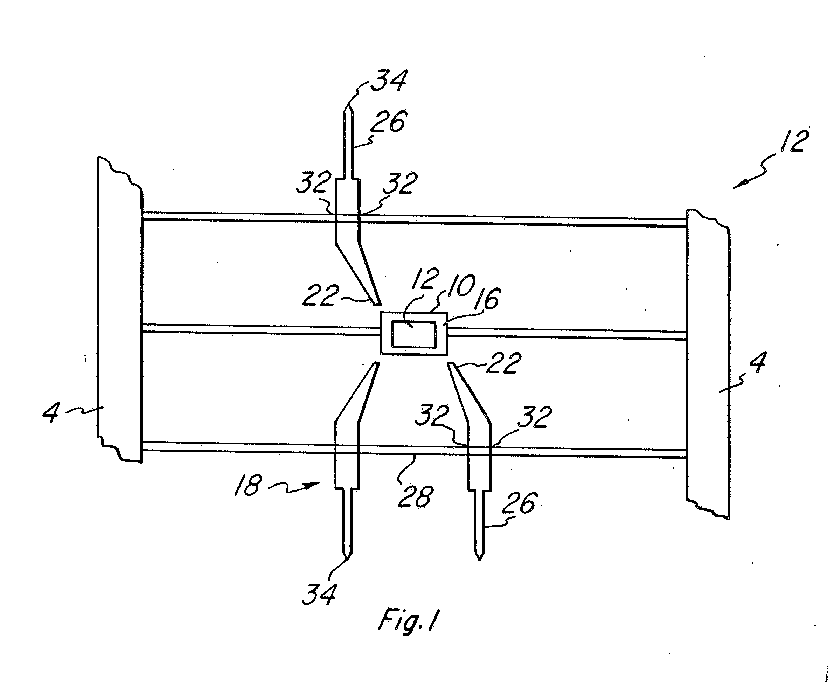

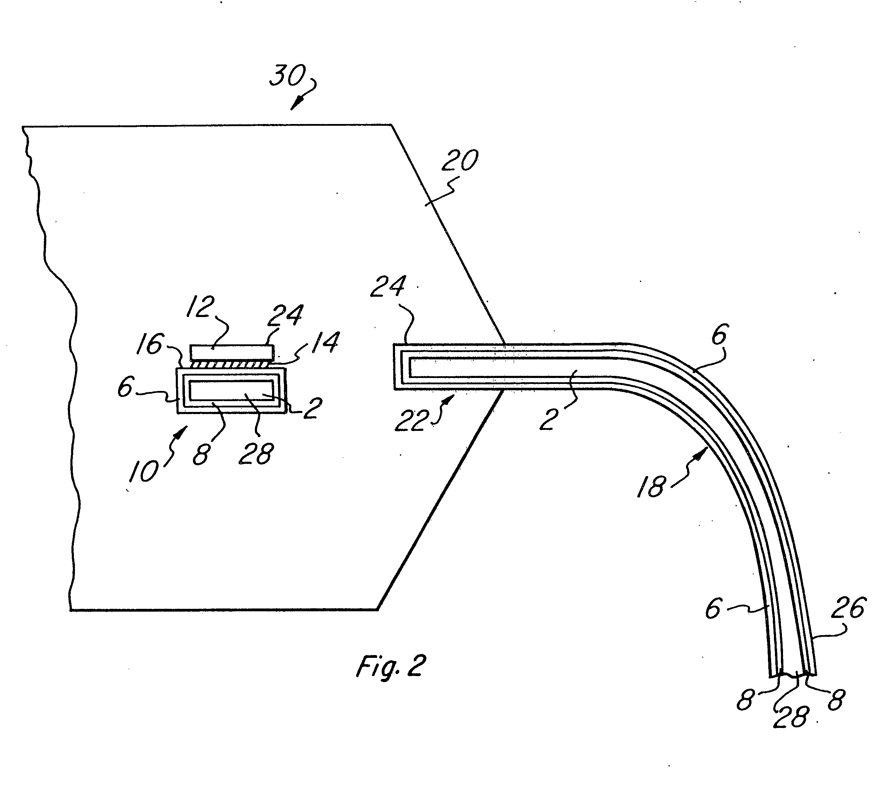

Turning to Figures 1 and 2, a lead frame 2 or a plurality of such lead frames connected to each other by connecting strips 4 are prepared for flood plating first with nickel 8 and then with palladium 6. Nickel is used to prepare the base metal for the layer of plated palladium. The palladium layer 6 and the nickel layer 8 are each deposited in a layer which is substantially uniform in thickness. Thus, no discontinuities in lead frame thickness arise from the plating process.

Another embodiment of the invention is to replace the palladium layer 6 with a plated layer 6 of palladium-nickel alloy consisting of 80% palladium and 20% nickel.

The palladium plate covers all the surfaces of the lead frame prior to the usual step of trimming excess metal from the lead frame. Refer now to Figure 1. As is standard with prior art devices, the dam bars 28 are trimmed away after the packaging medium 20 has been applied. Also, adjoining lead frames in a strip of a plurality of lead frames are trimmed to separate them one from the other. After the trimming process is complete, however, the remaining members of the lead frame still have substantially all of their surfaces covered with a layer of palladium. The areas of exposed base metal 28 will be, chiefly, the small areas 32 on each external lead 26 where the dam bars 28 have been cut away, and the external lead tips 34 which are cut to separate them from the strip of lead frames.

It will be appreciated that although it is most economical and the preferred method is to plate a plurality of lead frames 2 connected by strips 4, the invention embraces palladium plating of lead frames singly or plurally no matter how connected. It will also be appreciated that although palladium flood plating is the preferred method, palladium spot plating or any other plating method is also encompassed by the invention.

Flood plating is a term well known in the art and refers to plating an entire object by immersion. Spot plating is also a term of art and refers to plating an object in circumscribed areas or spots, as by masking the portions of the object not to be plated.

As shown in Figure 1, the lead frame 2 is comprised of several members, such as the leads 18 and the semiconductor support member 10. Adjacent leads are mechanically connected by dam bars 28. After the packaging medium 20 is in place surrounding all but the external leads 26, the dam bars are removed.

Turning now to Figure 2, a palladium plated semiconductor support member 10 is shown with a semiconductor integrated circuit 12 attached by an adhesive 14 to the upper surface 16 of the semiconductor support member. The adhesive 14 preferably is electrically conductive to form a good electrical connection between the base of the integrated circuit 12 and the palladium plated upper surface 16 of support member 10.

Continuing with Figure 2, lead 18 is supported mechanically by the packaging medium 20, which may be a material such as plastic or ceramic. The packaging medium surrounds, protects, and mechanically supports the leads 18, semiconductor support member 10, and integrated circuit 12. The lead portion nearest the semiconductor support member 10 is referred to as the lead end 22, and is electrically connected to the integrated circuit 12 via a wire 24 which, typically, is made of gold. The gold wire is bonded directly to the palladium plated upper surface of lead end 22, thermosonically or by another suitable technique. Thermosonic bonding is a well known technique and, essentially, consists of a combination of heat and sonic energy delivered via a wand to the combination of metals to be bonded.

As seen in Figure 2, palladium plated external lead 26 protrudes from the packaging medium 20 and is ready to be electrically connected to other electrical or electronic parts, such as by soldering or mechanically as with clips or sockets. Typically, the external leads of the integrated circuit device 30 are connected to components such as resistors, capacitors, other integrated circuit devices, or equipment such as meters and oscilloscopes for testing purposes.

The base metal for either of the illustrated embodiments may be chosen from such well known alloys as : Alloy 42 which, roughly, is 42% nickel, 58% iron, and small amounts of several other elements; any one of several copper alloys used for lead frames; 400 stainless steel; and copper/stainless steel/copper clad metals. These alloys are well known. in the art and are commonly used for lead frame construction.

Although the invention has been described with a certain degree of specificity, it is obvious to one skilled in the art that variations can be made to the disclosed embodiments without varying from the scope of the invention, which scope is set forth by the appended claims.

## Claims

1. A lead frame comprising:
palladium, or palladium-nickel alloy, plated lead means for electrical connection to electrical components, wherein the palladium, or palladium-nickel alloy, plated layer is the outermost plated layer; and
semiconductor support means for electrically contacting a semiconductor integrated circuit;
wherein the palladium, or palladium-nickel alloy, plated lead means include palladium, or palladium-nickel alloy, plated external lead means for electrical connection to external electrical parts.

2. The lead frame according to Claim 1 wherein the palladium, or palladium-nickel alloy, plated lead means include:
palladium, or palladium-nickel alloy, plated lead end means for electrical connection to the semiconductor integrated circuit.

3. The lead frame according to Claim 2 wherein the semiconductor support means is palladium, or palladium-nickel alloy, plated, and wherein the palladium, or palladium-nickel alloy, plated layer is the outermost plated layer.

4. The lead frame according to Claim 3 wherein the palladium, or palladium-nickel alloy, plated lead means is a plurality of palladium, or palladium-nickel alloy, plated lead means for electrically connecting the plurality of palladium, or palladium-nickel alloy, plated lead end means to a plurality of points on the semiconductor integrated circuit.

5. An integrated circuit device comprising:
the lead frame of Claim 4;
semiconductor integrated circuit means; and
a plurality of wire means for electrically connecting the plurality of palladium, or palladium-nickel alloy, plated lead end means to a plurality of points on the semiconductor integrated circuit means.

6. The integrated circuit device according to Claim 5 wherein the plurality of wire means are bonded to the plurality of palladium, or palladium-nickel alloy, plated lead end means.

7. The integrated circuit device according to Claim 6 further comprising:
electrically conductive adhesive means for electrically and mechanically connecting the semiconductor integrated circuit means to the semiconductor support means.

8. The integrated circuit device according to Claim 7 further comprising:
a packaging medium for supporting and protecting the lead frame and semiconductor integrated circuit means.

9. The integrated circuit device according to Claim 8 wherein the plurality of wire means are a plurality of gold wire means.

10. The integrated circuit device according to Claim 9 wherein the packaging medium is plastic.

11. The lead frame according to Claim 4 wherein the palladium, or palladium-nickel alloy, plated lead means and the palladium, or palladium-nickel alloy, plated semiconductor support means include nickel plated layer means for preparing the lead means and semiconductor support means for palladium, or palladium-nickel alloy, plating.

12. A method of plating a lead frame comprising the steps of:
Flood plating a lead frame with an outermost plated layer of palladium, or palladium-nickel alloy, to form the outer surface of the lead frame, wherein the lead frame includes a plurality of leads and a semiconductor support means.

13. The method of plating a lead frame as set forth in Claim 12, further comprising the steps of:
preparing the lead frame for the palladium, or palladium-nickel alloy, plating step by first flood plating the lead frame with nickel.

14. The method of plating a lead frame as set forth in Claim 12 wherein the palladium, or palladium-nickel alloy, plating step is carried out to provide a plated layer which is substantially uniform in thickness for good package stress characteristics.

15. The method of plating a lead frame as set forth in Claim 13 wherein the nickel plating step and the palladium, or palladium-nickel alloy, plating step are carried out to provide plated layers of substantially uniform thickness for good package stress characteristics.

Fig.1

Fig. 2

0 250 146

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 9, no. 19 (E-292)[1742], 25th January 1985; & JP-A-59 168 659 (FURUKAWA DENKI KOGYO K.K.) 22-09-1984 * Abstract * | 1-6,11 -15 | H 01 L 23/48 |
| A | Idem | 8-10 | |
| X | PATENT ABSTRACTS OF JAPAN, vol. 9, no. 118 (E-316)[1841], 23rd May 1985; & JP-A-60 7161 (MASAMI KOBAYASHI) 14-01-1985 * Abstract * | 1-4,11 -15 | |
| X | EP-A-0 127 857 (MASAMI KOBAYASHI) * Page 14, line 12 - page 15, line 34 * | 1-4,11 | **TECHNICAL FIELDS SEARCHED (Int. Cl.4)** |
| A | | 12-15 | H 01 L |
| A | US-A-3 443 914 (NEC) | | |
| A | EP-A-0 114 338 (TOSHIBA) | | |

The present search report has been drawn up for all claims

| Place of search | Date of completion of the search | Examiner |
|---|---|---|
| THE HAGUE | 07-09-1987 | CAMPLING N.C.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO Form 1503 03.82